# EUROPEAN PATENT APPLICATION

(11) **EP 3 518 052 A1**
(43) Date of publication of application: **31.07.2019**
(21) Application number: 17814303.8
(22) Date of filing: 10.03.2017
(51) Int. Cl.: G05B 19/042

(54) **VOICE PROMPT SYSTEM AND METHOD FOR MOBILE POWER SUPPLY, AND MOBILE POWER SUPPLY**

(30) Priority: 26.09.2016 CN 201610849897
(71) Applicant: JRD Communication (Shenzhen) Ltd, Shenzhen, Guangdong 518052 (CN)
(72) Inventor: DIAO, Zhiming, Shenzhen, Guangdong 518057 (CN); TONG, Hongjie, Shenzhen, Guangdong 518057 (CN)
(74) Representative: ZHAOffice SPRL
(86) International application number: PCT/CN2017/076310
(87) International publication number: WO 2018/054023

(57) **Abstract**

The present disclosure discloses a mobile power supply as well as a voice prompting system and method thereof. The voice prompting system for a mobile power supply includes: a programmer configured to input all reminder information into an MCU based on mobile power supply state information; the MCU configured to store all the reminder information, and search the corresponding reminder information based on the current mobile power supply state information when receiving an interrupt trigger signal; and a voice prompting module configured to convert signal of the reminder information into signal of voice information so as to playback. Which are capable of outputting a corresponding voice information according to current mobile power supply state information and playbacking to the users, so as to resolve the problems for the blind users or the users who are not convenient to view the mobile power supply and cannot know the current state of mobile power supply information, thereby providing the users with conveniences.

## Description

### TECHNICAL FIELD

Embodiments of the present disclosure generally relate to mobile power supply technology, and in particular relate to a mobile power supply as well as a voice prompting system and method thereof.

### BACKGROUND

With the increasing of the consumer demand for the battery life of smart phones, the consumer demand cannot meet by merely increasing the battery capacity. Hence, there emerges more and more mobile power supplies in the current market, which help users to charge smart phones anytime and anywhere.

However, the mobile power supplies sold in the current market mostly use an LED assembly or an LCD screen to realize electric quantity display schemes, which is not convenient in the scene which the mobile power supply cannot be picked up or for some special users such as blinds.

Consequently, the prior art has to be improved and enhanced.

### SUMMARY

In view of the above deficiencies of the prior art, it is an objective of the present disclosure to provide a mobile power supply as well as a voice prompting system and method thereof, which are capable of outputting a corresponding voice information according to current mobile power supply state information and playbacking to the users, so as to resolve the problems for the blind users or the users who are not convenient to view the mobile power supply and cannot know the current state of the current mobile power supply, thereby providing the users with conveniences.

In order to achieve the above-mentioned objective, the present disclosure adopts the following technical scheme:
a voice prompting method for a mobile power supply, comprising:
   A, inputting all reminder information into an MCU based on mobile power supply state information through a programmer;
   B1, monitoring current mobile power supply state information to output to the MCU through a state monitoring module;
   B, storing all the reminder information through the MCU, and searching the corresponding reminder information based on the current mobile power supply state information when receiving an interrupt trigger signal; and
   C, converting signal of the reminder information into signal of voice information through a voice prompting module so as to playback;
wherein, the step C comprises:
   C1, converting signal of the reminder information into signal of speech information through a digital-to-analog converter;
   C2, amplifying signal of the speech information through a power amplifier; and
   C3, playbacking the speech information through a speaker after signal of the speech information is amplified.
a voice prompting system for a mobile power supply, comprising:
a programmer configured to input all reminder information into an MCU based on mobile power supply state information;
the MCU configured to store all the reminder information, and search the corresponding reminder information based on the current mobile power supply state information when receiving an interrupt trigger signal; and
a voice prompting module configured to convert signal of the reminder information into signal of voice information so as to playback.
a mobile power supply comprising the above-mentioned voice prompting system.

Compared with the prior art, in the mobile power supply as well as the voice prompting system and method thereof provided by the present disclosure, the voice prompting system for a mobile power supply comprises: the programmer configured to input all reminder information into an MCU based on mobile power supply state information; the MCU configured to store all the reminder information, and search the corresponding reminder information based on the current mobile power supply state information when receiving an interrupt trigger signal; and the voice prompting module configured to convert signal of the reminder information into signal of voice information so as to playback. Which are capable of outputting a corresponding voice information according to current mobile power supply state information and playbacking to the user, so as to resolve the problems for the blind users or the users who are not convenient to view the mobile power supply and cannot know the current state of mobile power supply information, thereby providing the users with conveniences.

### BRIEF DESCRIPTION OF THE DRAWINGS

FIG. 1 is a block diagram of a voice prompting system for a mobile power supply according to an embodiment of the present disclosure.
FIG. 2 is a flow chart of a voice prompting method for a mobile power supply according to an embodiment of the present disclosure.

### DETAILED DESCRIPTION

In view of the defects of the prior art which includes the prompting method of the state information such as the electric quantity of a mobile power supply is too simple, it is an objective of the present disclosure to provide a mobile power supply as well as a voice prompting system and method thereof, which are capable of outputting a corresponding voice information according to current mobile power supply state information and playbacking to a user, so as to resolve the problems for the blind users or the users who are not convenient to view the mobile power supply and cannot know the state information of current mobile power supply, thereby providing the user with conveniences.

In order to make the objective and technical scheme of the present disclosure more clear and definite, the present disclosure will now be described in more detail with reference to the accompanying drawings as follows. It is to be understood that the specific embodiments described herein are merely illustrative of the present disclosure and are not intended to limit the present disclosure.

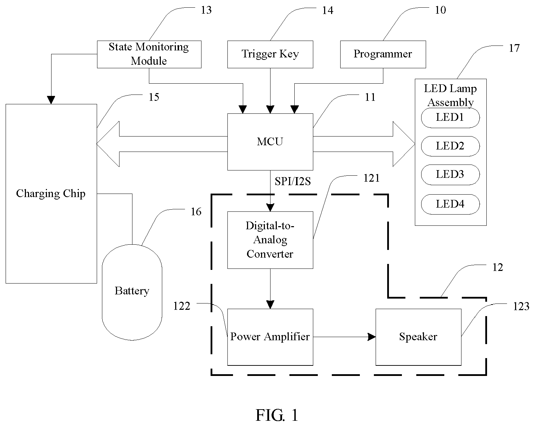

Referring to FIG. 1, a voice prompting system for a mobile power supply which is provided by the present disclosure includes a programmer 10, an MCU 11, and a voice prompting module 12. The MCU 11 is coupled to the programmer 10 and the voice prompting module 12. The programmer 10 is configured to input all reminder information into the MCU 11 based on mobile power supply state information. The MCU 11 is configured to store all the reminder information, and search the corresponding reminder information based on the current mobile power supply state information when receiving an interrupt trigger signal. The voice prompting module 12 is configured to convert signal of the reminder information into signal of voice information so as to playback. As a result, the corresponding voice information can be outputted based on the current mobile power supply state information and playback to the user, which perfects the information prompting function of the mobile power supply and gives the user a more user-friendly experience. The MCU 11 is further connected to a charging chip 15 and a battery 16 in turn to control the charging and discharging function of the mobile power supply. In this embodiment, the MCU 11 is of the type MSP430G2332, the charging chip 15 is of the type BQ24295, and the capacity of the battery 16 is preferably 3000 mAh.

In a specific implementation, all the reminder information corresponding to the mobile power supply state information is inputted into the MCU 11 through the programmer 10 first. The mobile power supply state information can be, for example, the particular electric quantity of the mobile power supply, whether connected to a mobile terminal, whether the current electric quantity is too low, etc. Then these state information is burned into the MCU 11 through programming, and all the reminder information is stored through the MCU 11. After that, when an interrupt trigger signal is received, the stored corresponding reminder information is searched based on the current mobile power supply state information, for example, if the current mobile power supply state is being discharged and the remaining electric quantity is 50%, the MCU 11 searches the two corresponding reminder information from the stored reminder information when the interrupt trigger signal is received and outputs to the voice prompting module 12. The voice prompting module 12 converts signal of the reminder information into signal of speech information and playbacks. At the time, the user can hear the voice information of "discharging, the remaining electric quantity is 50%", so as to realize the voice reporting function of the mobile power supply state information, thereby resolving the problems for the blind users or the users who are not convenient to view the mobile power supply and cannot know the state information of the current mobile power supply.

Preferably, the voice prompting system for a mobile power supply which is provided by the present disclosure includes a trigger key 14 configured to receive press information of the user and generate the interrupt trigger signal to output to the MCU11. The trigger key 14 is coupled to the MCU 11. When the user want to know the state information of the mobile power supply while not convenient to pick up the mobile terminal, or when used by the blind users, the interrupt trigger signal can be generated through the trigger key 14, so as to turn on a voice playback function. Specifically, a high-touch blind key is adopted as the trigger key 14, so as to provide a more user-friendly experience to the special users.

Furthermore, the voice prompting system for a mobile power supply which is provided by the present disclosure further includes a state monitoring module 13. The state monitoring module 13 is coupled to the MCU 11 and the charging chip 15. The state monitoring module 13 is configured to monitor the current mobile power supply state information to output to the MCU 11. That is, the state information of the current mobile power supply such as charge / discharge information and electric quantity information is detected in real time through the state monitoring module 13 and outputted to the MCU 11, such that the MCU 11 can output the most accurate reminder information based on the state information monitored in real time when receiving the interrupt trigger signal, so as to ensure the accuracy of the prompts of the state information.

In particular, the voice prompting module 12 includes a digital-to-analog converter 121, a power amplifier 122, and a speaker 123. The digital-to-analog converter 121, the power amplifier 122, and the speaker 123 are connected in turn. The digital-to-analog converter 121 is connected to the MCU 11 through an SPI/I2S interface. Wherein the digital-to-analog converter 121 is configured to convert the signal of reminder information into signal of speech information; the power amplifier 122 is configured to amplify signal of the speech information; the speaker 123 is configured to playback signal of the speech information after signal of the speech information is amplified. After the MCU 11 searches the corresponding reminder information based on the current mobile power supply state information, it is transmitted to the digital-to-analog converter 121 through the SPI / I2S interface. The digital-to-analog converter 121 converts signal of the reminder information into signal of the voice information, then the power amplifier 122 amplifies signal of the voice information and outputs to the speaker 123 to playback. Through an audio output structure adopting the SPI interface, the digital-analog converter 121, and the power amplifier 122, the accuracy and the loudness of the reminder of the voice information is ensured, thereby guaranteeing that the user can know the current mobile power supply state information clearly and accurately.

At the same time, in order to allow the user to know the electric quantity of the current battery 16 more clearly and to estimate the battery life, an LED lamp assembly 17 including a plurality of LED lamps is adopted to display the electric quantity information of the current battery 16, that is, the amount of the current lit LED lamp is proportional to the electric quantity of the current battery 16, and the user can know the remaining electric quantity of the current battery 16 at a glance. The amount of the LED lamp is preferably four, and it is of course possible to increase or decrease the amount of the LED lamp as required. In this embodiment, the LED lamp assembly 17 adopts a plurality of surface mounted LEDs of the type LED0603.

Preferably, the voice prompting system for a mobile power supply is further provided with a low pressure difference linear regulator LD0 (not shown) for voltage regulation and an overcurrent protection chip (not shown) for current limiting protection, so as to ensure the stability and safety of charges. The low pressure difference linear regulator LD0 is of the type SGM2021_3V, and the over-current protection chip is of the type TPS2553.

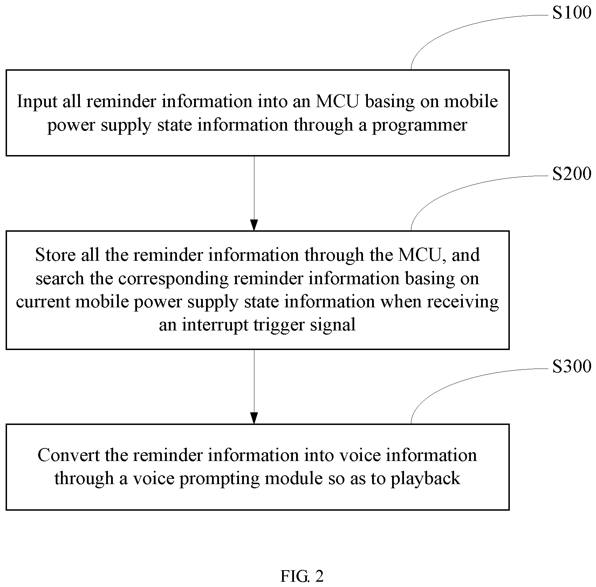

The present disclosure further provides a voice prompting method for a mobile power supply. Referring to FIG. 2, a flow chart of a voice prompting method for a mobile power supply according to an embodiment of the present disclosure is depicted. The method may includes the following blocks:
At S100: inputting all reminder information into an MCU based on mobile power supply state information through a programmer.
At S200: storing all the reminder information through the MCU, and searching the corresponding reminder information based on current mobile power supply state information when receiving an interrupt trigger signal.
At S300: converting signal of the reminder information into signal of voice information through a voice prompting module so as to playback.

Furthermore, after S100 and before S200 further includes the following blocks:
At S211: monitoring the current mobile power supply state information to output to the MCU through a state monitoring module.

Still furthermore, after S100 and before S211 further includes the following block.

At S210: receiving user press information and generating interrupt trigger signal to output to the MCU through a trigger key.

In particular, S300 includes the following blocks:
At S301 :converting signal of the reminder information into signal of speech information through a digital-to-analog converter;
At S302: amplifying signal of the speech information through a power amplifier.
At S303: playbacking the speech information through a speaker after signal of the speech information is amplified.

The present disclosure still further provides a mobile power supply which includes the above-mentioned voice prompting system for the mobile power supply. Since the voice prompting system for the mobile power supply has been described in detail as above, which is not described in detail herein.

In view of the above, in the mobile power supply as well as the voice prompting system and method thereof provided by the present disclosure, the voice prompting system for a mobile power supply includes: the programmer configured to input all reminder information into an MCU based on mobile power supply state information; the MCU configured to store all the reminder information through the MCU, and search the corresponding reminder information based on the current mobile power supply state information when receiving an interrupt trigger signal; and the voice prompting module configured to convert signal of the reminder information into signal of voice information so as to playback. Which are capable of outputting a corresponding voice information according to current mobile power supply state information and playbacking to the user, so as to resolve the problems for the blind users or the users who are not convenient to view the mobile power supply and cannot know the state information of the current mobile power supply, thereby providing the users with conveniences.

It is to be understood that it is possible for one of ordinary skill in the art to equivalently substitute or modify the embodiments in accordance with the technical solution of the present disclosure and the inventive concept thereof, and all such modifies or substitutes should be within the scope of the claims appended hereto.

## Claims

1. A voice prompting method for a mobile power supply, comprising:
A, inputting all reminder information into an MCU based on mobile power supply state information through a programmer;
B1, monitoring current mobile power supply state information to output to the MCU through a state monitoring module;
B, storing all the reminder information through the MCU, and searching the corresponding reminder information based on the current mobile power supply state information when receiving an interrupt trigger signal; and
C, converting signal of the reminder information into signal of voice information through a voice prompting module so as to playback;
wherein, the step C comprises:
C1, converting signal of the reminder information into signal of speech information through a digital-to-analog converter;
C2, amplifying signal of the speech information through a power amplifier; and
C3, playbacking the speech information through a speaker (123) after signal of the speech information is amplified.

2. The method of claim 1, wherein after step A and before step B1 further comprising:
B0, receiving user press information and generating interrupt trigger signal to output to the MCU through a trigger key.

3. A voice prompting system for a mobile power supply, comprising:
a programmer configured to input all reminder information into an MCU based on mobile power supply state information;
the MCU configured to store all the reminder information through the MCU, and search the corresponding reminder information based on the current mobile power supply state information when receiving an interrupt trigger signal; and
a voice prompting module configured to convert signal of the reminder information into signal of voice information so as to playback.

4. The system of claim 3, further comprising a state monitoring module configured to monitor current mobile power supply state information to output to the MCU.

5. The system of claim 3, further comprising a trigger key configured to receive user press information and generate interrupt trigger signal to output to the MCU.

6. The system of claim 3, wherein the voice prompting module comprises:
a digital-to-analog converter configured to convert signal of the reminder information into signal of speech information;
a power amplifier configured to amplify signal of the speech information;
a speaker configured to playback the speech information after signal of the speech information is amplified.

7. The system of claim 3, wherein the MCU is of the type MSP430G2332.

8. A mobile power supply comprising the voice prompting system of claim 3.

9. The mobile power supply of claim 8, further comprising a state monitoring module configured to monitor current mobile power supply state information to output to the MCU.

10. The mobile power supply of claim 8, further comprising a trigger key configured to receive user press information and generate interrupt trigger signal to output to the MCU.

11. The mobile power supply of claim 8, wherein the voice prompting module comprises:
a digital-to-analog converter configured to convert signal of the reminder information into signal of speech information;
a power amplifier configured to amplify signal of the speech information; and
a speaker configured to playback signal of the speech information after signal of the speech information is amplified.
